# DEMANDE DE BREVET EUROPEEN

(11) **EP 4 762 982 A1**
(43) Date de publication de la demande: **24.06.2026**
(21) Numéro de dépôt: 25213413.5
(22) Date de dépôt: 04.11.2025
(51) Int. Cl.: A44C 27/00, C23C 14/00, G02B 5/28, G04B 19/12, G04B 37/22, G04B 45/00

(54) **COMPOSANT D'HABILLAGE COMPRENANT UN EMPILEMENT DE COUCHES INTERFÉRENTIELLES DÉPOSÉ SUR UNE FACE RÉALISÉE EN CARBURE DE CHROME**

(30) Priorité: 20.12.2024 EP 24222435
(71) Demandeur: The Swatch Group Research and Development Ltd, 2074 Marin (CH)
(72) Inventeur: HALLER, Camille, 1400 Yverdon-les-Bains (CH); CURCHOD, Loïc, 1004 Lausanne (CH); BAUDOZ, Marie, 25500 Morteau (CH); POLY, Giovanni, 25120 Maiche (FR)
(74) Mandataire: ICB SA

(57) **Abrégé**

L'invention concerne un composant d'habillage (10) comprenant un substrat (100) présentant une face support (101) réalisée en carbure de chrome CrₓC_{y} dont l'indice de réfraction complexe à une longueur d'onde de 550 nm présente une partie réelle n>1 et une partie imaginaire k<1,5, sur laquelle est déposé un empilement de couches minces diélectriques (110) formé par au moins une alternance de couches réalisées en TiO₂ et Al₂O₃ et comportant une couche terminale (111) réalisée en TiO₂ et une couche de base (112) reposant sur la face support (101) réalisée en TiO₂ ou en Al₂O₃.

## Description

### Domaine technique de l'invention

L'invention relève du domaine de l'horlogerie, de la bijouterie ou de la joaillerie, et concerne plus particulièrement un composant d'habillage d'horlogerie, de bijouterie ou de joaillerie.

Dans le présent texte, les termes « composant d'habillage » désignent, de façon communément admise dans les domaines précités, un composant visible pour un utilisateur, et ayant une fonction notamment décorative, c'est-à-dire contribuant à l'aspect visuel d'un objet.

### Arrière-plan technologique

Dans les domaines de l'horlogerie, de la bijouterie ou de la joaillerie, l'aspect esthétique constitue généralement un objectif majeur.

Dans le domaine horloger par exemple, les composants d'habillage, par exemple les cadrans, permettent, pour une maison horlogère, notamment de se démarquer de ses concurrents, de participer à façonner l'identité d'une marque ou d'un modèle de montre.

Afin de colorer un composant d'habillage, il est connu de déposer un revêtement sur un substrat généralement réalisé en matériau métallique, par exemple par peinture, vernissage ou émaillage. Toutefois, ces procédés de coloration ne sont pas toujours adaptés dans la mesure où la couche de matière appliquée à la surface du substrat est trop épaisse pour laisser apparaitre d'éventuelles structurations de surface, par exemple une surface brossée, soleillée, sablée, structurée laser, etc., et d'autre part, la durée de vie de cette couche et par conséquent de sa couleur n'est pas toujours satisfaisante.

Ainsi, les techniques de dépôt de couches minces sous vide sont préférées, tels que les procédés de dépôt physique en phase vapeur (connu sous l'acronyme en langue anglaise « PVD » pour « Physical Vapor Deposition »), de dépôt chimique en phase vapeur (connu sous l'acronyme en langue anglaise « CVD » pour « Chemical Vapor Deposition »), et de dépôt de couches atomiques (connu sous l'acronyme en langue anglaise « ALD » pour « Atomic Layer Deposition »). En effet, ces techniques de dépôt de couches minces sous vide permettent de déposer des couches fines et résistantes, typiquement adaptées pour revêtir des pièces de petites dimensions comprenant par exemple une structuration de surface fine.

Toutefois, ces techniques de dépôt permettent de conférer à un composant d'habillage un nombre restreint de couleurs.

La présente invention vise à obtenir un composant d'habillage présentant une nouvelle gamme de couleurs et respectant l'aspect de toute éventuelle structuration du substrat.

### Résumé de l'invention

L'invention résout les inconvénients précités et concerne, à cet effet, un composant d'habillage d'horlogerie, de bijouterie ou de joaillerie, comprenant un substrat présentant une face support réalisée en carbure de chrome CrₓC_{y} dont l'indice de réfraction complexe à une longueur d'onde de 550 nm présente une partie réelle n>1 et une partie imaginaire k<1,5, sur laquelle est déposé un empilement de couches minces diélectriques semi-transparentes formé par au moins une alternance de couches réalisées en TiO₂ et Al₂O₃ et comportant une couche terminale réalisée en TiO₂ et une couche de base réalisée en TiO₂ ou en Al₂O₃ reposant sur la face support, la face support présentant une proportion atomique égale de carbone et de chrome. En outre, l'empilement de couches minces diélectriques comporte cinq couches, la couche de base étant réalisée en TiO₂, les couches de l'empilement de couches minces diélectriques présentant des épaisseurs choisies de sorte à conférer une couleur interférentielle au composant d'habillage caractérisée, dans l'espace CIELAB en mode réflexion de l'illuminant normalisé D65, avec un observateur de 10° et une géométrie de mesure di:8°, par les paramètres L* = [45 ; 55], a* = [-10 ; 0], b* = [0 ; 10].

L'invention permet avantageusement de conférer une couleur inédite au composant d'habillage, tout en lui assurant une protection chimique et environnementale. Avantageusement, la couleur conférée au composant d'habillage dépend du rapport stœchiométrique entre le carbone et le chrome au niveau de la face support.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la face support est une face d'une couche support réalisée en CrₓC_{y}.

### Brève description des figures

D'autres caractéristiques et avantages de l'invention apparaîtront à la lecture de la description détaillée suivante donnée à titre d'exemple nullement limitatif, en référence aux figures dans lesquelles :
- la figure 1 représente schématiquement une vue de section d'un composant d'habillage selon présente invention dans une première variante d'un premier exemple de réalisation,
- la figure 2 représentent schématiquement une vue de section d'un composant d'habillage une seconde variante du premier exemple de réalisation,
- les figures 3 et 4 représentent schématiquement une vue de section d'un composant d'habillage respectivement selon une première et une seconde variante d'un second exemple de réalisation.

On note que les figures ne sont pas dessinées à l'échelle pour des raisons de clarté.

### Description détaillée de l'invention

La présente invention concerne un composant d'habillage 10 d'horlogerie, de bijouterie ou de joaillerie comprenant un substrat 100 présentant une face support 101 réalisée en carbure de chrome CrₓC_{y}.

En particulier, le substrat 100 peut être formé par un corps sur lequel est déposée une couche réalisée en CrₓC_{y}, par exemple par dépôt physique en phase vapeur, connu par l'homme du métier sous l'acronyme « PVD » en langue anglaise pour « Physical Vapor Deposition ». La face support 101 est alors formée par la couche de carbure de chrome ainsi déposée. Une telle couche peut présenter une épaisseur comprise entre 50 nm et 10 µm, et préférentiellement entre 50 nm et 500 nm.

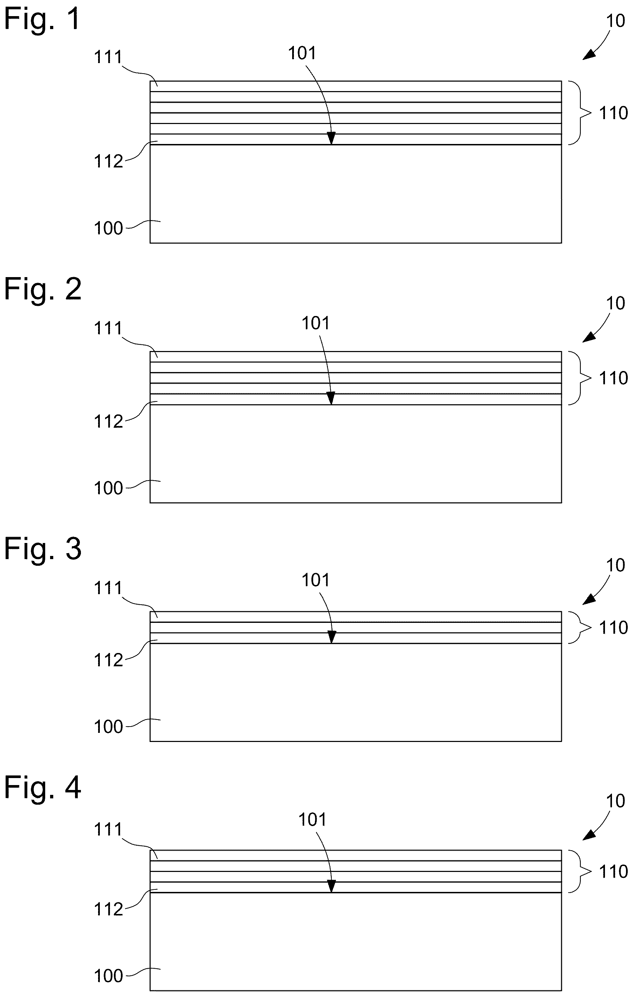

Le composant d'habillage 10 selon l'invention est représenté schématiquement sur la figure 1 et est particulièrement adapté à former un cadran pour une pièce d'horlogerie, ou toute autre pièce préférentiellement interne de la pièce d'horlogerie.

Le composant d'habillage 10 comporte sur sa face support 101, un empilement de couches minces diélectriques 110 semi-transparentes, c'est-à-dire au moins transparentes dans le domaine du visible. Les couches de l'empilement de couches minces diélectriques 110 sont déposées par une méthode de dépôt de couches minces atomiques connu par l'homme du métier sous l'acronyme « ALD » en langue anglaise pour « Atomic Layer Deposition ». Chaque couche de l'empilement de couches minces diélectriques 110 présente une épaisseur comprise entre quelques nanomètres et quelques dizaines de nanomètres. Cette caractéristique permet à la fois de protéger la face support 101 du composant d'habillage 10 contre les agressions chimiques et environnementales, tel que l'humidité, et de la colorer par effet interférentiel précisément choisi et de façon répétable et robuste. Aussi, l'épaisseur de l'empilement de couches minces diélectriques 110 est homogène et conforme sur l'ensemble de sa surface.

La face support 101 peut présenter une structuration, par exemple réalisée par usinage mécanique, par exemple une gravure manuelle ou un usinage avec une machine-outil à commande numérique, par usinage chimique ou au laser. La structuration est formée par des creux et des sommets, la distance entre les creux et les sommets étant, par exemple, égale à au moins 1 µm.

L'empilement de couches minces diélectriques 110 est formé par au moins une alternance de couches réalisées en TiO₂ et Al₂O₃ et comporte une couche terminale 111 réalisée en TiO₂ et une couche de base 112 reposant sur la face support 101 réalisée en TiO₂ ou en Al₂O₃.

On comprend ici que la nature de la couche de base 112 dépend du nombre de couches minces diélectriques 110, et en particulier de si le nombre de couches minces diélectriques est pair ou impair.

La couleur interférentielle obtenue par la combinaison de l'empilement de couches minces diélectriques 110 et de la face support 101 dépend notamment de l'épaisseur de chaque couche mince diélectrique 110, de leur agencement et de leur nombre, et du matériau constituant la face support 101.

En particulier, la présente invention propose un agencement particulier de l'empilement de couches minces diélectriques 110 associé à une face support 101 réalisée en carbure de chrome dont les rapports stœchiométriques sont choisis de sorte que l'indice de réfraction complexe à une longueur d'onde de 550 nm présente une partie réelle n>1 et une partie imaginaire k<1,5.

Avantageusement, grâce au choix de la nature et l'épaisseur des couches de l'empilement de couches minces diélectriques 110 ainsi que du matériau de la face support 101, et en particulier du rapport stœchiométrique entre le carbone et le chrome de la face support 101, la couleur interférentielle générée par les caractéristiques de l'invention est très précise et peut être choisie dans une gamme étendue de couleurs.

En particulier, dans un premier exemple de réalisation de la présente invention représenté sur la figure 1, la face support 101 présente une proportion atomique égale de carbone et de chrome. La couleur intrinsèque est alors grise avec un ton jaune, ce qui, en combinaison avec l'empilement de couches minces diélectriques 110, permet d'atteindre une gamme de couleurs difficiles à obtenir autrement qu'avec les caractéristiques de l'invention.

Dans une première variante de cet exemple de réalisation, correspondant à la présente invention, l'empilement de couches minces diélectriques 110 comporte six couches, la couche de base 112 étant réalisée en Al₂O₃. Les couches de l'empilement de couches minces diélectriques 110 présentent des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [15 ; 25], a* = [35 ; 45], b* = [15 ; 25], et plus précisément par les paramètres L* = 22, a* = 39, b* = 19.

Ainsi, dans cette première variante, le composant d'habillage 10 présente une couleur comprise dans les nuances de rouge, par exemple un rouge bordeaux ou un rouge orangé.

Dans une seconde variante de cet exemple de, telle que représentée sur la figure 2, l'empilement de couches minces diélectriques 110 comporte cinq couches, la couche de base 112 étant réalisée en TiO₂. Les couches de l'empilement de couches minces diélectriques 110 présentent des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [45 ; 55], a* = [-10 ; 0], b* = [0 ; 10], et plus précisément par les paramètres L* = 50, a* = -7, b* = 7.

Ainsi, dans cette seconde variante, le composant d'habillage 10 présente un aspect vert foncé.

Chaque couche de l'empilement de couches minces diélectriques 110 peut présenter, dans cet exemple de réalisation de l'invention, une épaisseur comprise entre un ou quelques nanomètres, par exemple entre 1 nm et 10 nm, et quelques dizaines de nanomètres, par exemple entre 80 nm et 90 nm.

Dans un second exemple de réalisation, la face support 101 présente une proportion atomique de chrome inférieure à celle de carbone.

Dans une première variante de cet exemple de réalisation visible sur la figure 3, la face support 101 peut présenter un pourcentage atomique de carbone supérieur à 60%. La couleur intrinsèque est alors comprise dans une nuance de gris foncé avec un ton plus neutre que le premier exemple, ce qui, en combinaison avec l'empilement de couches minces diélectriques 110, permet d'atteindre une gamme de couleurs difficiles à obtenir autrement qu'avec les caractéristiques de l'invention.

Dans cette variante, l'empilement de couches minces diélectriques 110 peut comporter trois couches, la couche de base 112 étant réalisée en TiO₂. Les couches de l'empilement de couches minces diélectriques 110 présentant des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [70 ; 80], a* = [-10 ; 0], b* = [-5 ; 5], et plus précisément par les paramètres L* = 76, a* = -6, b* = -1.

Ainsi, dans cette première variante, le composant d'habillage 10 présente un aspect vert clair.

Dans une seconde variante représentée sur la figure 4, la face support 101 peut présenter un pourcentage atomique de carbone supérieur à 80%. La couleur intrinsèque est alors comprise dans une nuance de gris très foncé, voire noir, ce qui, en combinaison avec l'empilement de couches minces diélectriques 110, permet d'atteindre une gamme de couleurs difficiles à obtenir autrement qu'avec les caractéristiques de l'invention.

Dans cette variante, l'empilement de couches minces diélectriques 110 comporte quatre couches, la couche de base 112 étant réalisée en Al₂O₃. Les couches de l'empilement de couches minces diélectriques 110 présentent des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [35 ; 45], a* = [-5 ; 5], b* = [-10 ; -20], et plus précisément par les paramètres L* = 40, a* = -3, b* = -15.

Ainsi, dans cette variante, le composant d'habillage 10 présente un aspect bleu.

Dans ce second exemple de réalisation de l'invention, chaque couche de l'empilement de couches minces diélectriques 110 peut présenter une épaisseur comprise entre un ou quelques nanomètres, par exemple entre 5 nm et 10 nm, et quelques dizaines de nanomètres, par exemple entre 70 nm et 80 nm.

De manière plus générale, il est à noter que les modes de mise en œuvre et de réalisation considérés ci-dessus ont été décrits à titre d'exemples non limitatifs, et que d'autres variantes sont par conséquent envisageables.

## Revendications

1. Composant d'habillage (10) d'horlogerie, de bijouterie ou de joaillerie, **caractérisé en ce qu'**il comprend un substrat (100) présentant une face support (101) réalisée en carbure de chrome CrₓC_{y} dont l'indice de réfraction complexe à une longueur d'onde de 550 nm présente une partie réelle n>1 et une partie imaginaire k<1,5, sur laquelle est déposé un empilement de couches minces diélectriques (110) semi-transparentes formé par au moins une alternance de couches réalisées en TiO₂ et Al₂O₃ et comportant une couche terminale (111) réalisée en TiO₂ et une couche de base (112) réalisée en TiO₂ ou en Al₂O₃ reposant sur la face support (101), la face support (101) présentant une proportion atomique égale de carbone et de chrome, et l'empilement de couches minces diélectriques (110) comportant cinq couches, la couche de base (112) étant réalisée en TiO₂, les couches de l'empilement de couches minces diélectriques (110) présentant des épaisseurs choisies de sorte à conférer une couleur interférentielle au composant d'habillage (10) caractérisée, dans l'espace CIELAB en mode réflexion de l'illuminant normalisé D65, avec un observateur de 10° et une géométrie de mesure di:8°, par les paramètres L* = [45 ; 55], a* = [-10 ; 0], b* = [0 ; 10]..

2. Composant d'habillage (10) selon la revendication 1, dans lequel la face support (101) est une face d'une couche support réalisée en CrₓC_{y} sur un corps de substrat.

3. Composant d'habillage (10) selon la revendication 1 ou 2, dans lequel les couches de l'empilement de couches minces diélectriques (110) présentent des épaisseurs choisies de sorte à conférer une couleur interférentielle au composant d'habillage (10) caractérisée, dans l'espace CIELAB en mode réflexion de l'illuminant normalisé D65, avec un observateur de 10° et une géométrie de mesure di:8°, par les paramètres L* = 22, a* = 39, b* = 19.
